# EUROPÄISCHE PATENTSCHRIFT

(11) **EP 1 870 491 B1**
(45) Veröffentlichungstag und Bekanntmachung des Hinweises auf die Patenterteilung: **27.05.2015**
(21) Anmeldenummer: 06012849.3
(22) Anmeldetag: 22.06.2006
(51) Int. Cl.: C23C 18/30, C23C 18/54

(54) **Verbessertes Verfahren zur Direktmetallisierung von elektrisch nicht leitfähigen Substratoberflächen, insbesondere Polyimidoberflächen**
Improved process for the direct metallisation of nonconductive substrates, particularly polyimide surfaces
Procédé amelioree de métallisation directe des substrat non-conductive, particuliérement des surface polyimide

(43) Veröffentlichungstag der Anmeldung: 26.12.2007
(73) Patentinhaber: Enthone, Inc., West Haven, CT 06516 (US)
(72) Erfinder: Kronenberg, Walter, Dr., 40227 Düsseldorf (DE); Hupe, Jürger, Dr., 40764 Langenfeld (DE)
(74) Vertreter: Michalski Hüttermann & Partner Patentanwälte mbB

(56) Entgegenhaltungen:
- WO-A-02/095091
- DE-A1- 4 205 190
- DE-A1- 10 220 684
- DE-C1- 3 806 884
- US-A- 5 194 313

## Beschreibung

Die vorliegende Erfindung betrifft ein verbessertes Verfahren zur Direktmetallisierung von elektrisch nicht leitfähigen Substratoberflächen, insbesondere von Polyimidoberflächen.

Die Direktmetallisierung von elektrisch nicht leitfähigen Substraten spielt insbesondere bei der Herstellung von Leiterplatten und gedruckten Schaltungen eine wichtige Rolle im Rahmen moderner Fertigungsprozesse. Leiterplatten werden üblicherweise aus glasfaserverstärkten Epoxydharzen, Polyimiden oder anderen geeigneten polymeren Kunststoffen gefertigt. Vielfach werden solche Leiterplatten als Mehrlagenschaltungen hergestellt, bei welchen sich unterschiedliche Leitungsbildebenen übereinander befinden. Die einzelnen Leitungsebenen müssen durch sogenannte Durchkontaktierungen miteinander verbunden werden. Sowohl beim Aufbringen des Leitungsbildes mit Hilfe von Masken oder anderer geeigneter Verfahren, als auch bei der Herstellung einer hinreichenden Leitfähigkeit innerhalb der Durchkontaktierungen werden neben chemischen Kupferabscheideverfahren auch Direktmetallisierungsverfahren im Stand der Technik eingesetzt.

Neben diesen Anwendungen wird die Kunststoffdirektmetallisierung auch im Bereich der dekorativen Beschichtungen wie beispielsweise im Bereich der Armaturentechnik, der Schmuckherstellung oder des Automobilbaus eingesetzt.

Seit längerem ist es schon im Stand der Technik üblich, nicht leitfähige Kunststoffsubstrate unter Verzicht einer vorherigen chemischen Metallisierung direkt galvanisch zu beschichten. Ein derartiges Verfahren ist beispielsweise in der US-PS 30 99 608 und DE-OS 33 04 004 beschrieben worden. Die dort beschriebenen Verfahren haben jedoch keinen Eingang in die Praxis gefunden. Begründet lag dies vor allem darin, dass nur mit frisch zubereiteten Lösungen einigermaßen brauchbare Ergebnisse erzielt werden konnten. Schon rasch nach Inbetriebnahme dieser sank die Qualität der erhaltenen Metallabscheidung, so dass nur noch unzureichende Ergebnisse erzielt wurden.

Aus den deutschen Offenlegungsschriften DE 1 299 740, DE 2 926 335 A1 und DE 31 32 218 A1 sind darüber hinaus Verfahren zur Herstellung von Durchkontaktierungen gedruckter Schaltungen unter Verwendung von Leitlacken sowie anschließender galvanischer oder stromloser Metallisierung bekannt.

Aus dem deutschen Patent DE 38 06 884 C1 ist ein Verfahren zur Herstellung von durchkontaktierten Leiterplatten auf Basis eines polymeren Trägermaterials oder Keramik durch galvanisches oder stromloses Auftragen einer Metallschicht auf den Oberflächen beschrieben, die nicht mit einer leitenden Metallschicht überzogen sind, welches dadurch gekennzeichnet ist, dass der Träger in einem oxidierend wirkenden Bad vorbehandelt wird, nach Entfernung der Badreste durch Spülen der Träger in ein Bad gebracht wird, welches ein Monomeres, insbesondere Pyrrol oder Pyrrolderivate, das in polymerer Form elektrisch leitend ist, enthält, und anschließend das so behandelte Substrat in ein saures Bad gebracht wird, wobei sich eine elektrisch leitende Schicht aus polymerisiertem Pyrrol oder Pyrrolderivaten ausbildet, woraufhin gegebenenfalls Badreste durch Spülen entfernt werden und galvanisch metallisiert wird.

Ausgehend von diesem Stand der Technik ist es die **Aufgabe** der vorliegenden Erfindung, ein verbessertes Verfahren zur direkten Metallisierung von nicht leitfähigen Substratoberflächen, insbesondere Polyimidoberflächen anzugeben.

**Gelöst** wird diese Aufgabe durch ein Verfahren zur Direktmetallisierung von nicht leitfähigen Substratoberflächen, insbesondere Polyimidoberflächen, welches gekennzeichnet ist durch die Verfahrensschritte:
- Beizen der Substratoberfläche mit einer sauren peroxid- oder peroxosulfathaltigen Beizlösung
- Kontaktieren der gebeizten Substratoberfläche mit einer sauren permanganathaltigen Behandlungslösung
- Aktivieren der behandelten Substratoberfläche in einer sauren oxidationsmittelhaltigen Aktivierungslösung
- Kontaktieren der aktivierten Substratoberfläche mit einer sauren, wenigstens ein Thiophenderivat und wenigstens ein Sulfonsäure oder ein Sulfonsäurederivat aufweisenden Behandlungslösung und
- Metallisieren der so behandelten Substratoberfläche in einem sauren galvanischen Metallisierungsbad.

Durch eine solche Ausgestaltung eines Verfahrens zur Direktmetallisierung von nicht leitenden Substratoberflächen wird der Stand der Technik dahingehend weitergebildet, dass eine zuverlässige Direktmetallisierung von nicht leitfähigen Substratoberflächen unter deutlich ökonomischeren und ökologischeren Verfahrensbedingungen möglich wird.

Insbesondere lassen sich durch eine solche Ausgestaltung der Verfahrensführung deutlich geringere Chemikalienmengen in den einzelnen Behandlungslösungen einsetzen, was zu einer verringerten Umweltbelastung führt.

Darüber hinaus kann durch die erfindungsgemäß gestaltete Verfahrensführung Stand der Technik mit deutlich verringerten Behandlungstemperaturen gearbeitet werden. Hierdurch lassen sich zusätzliche ökonomische und ökologische Vorteile erreichen.

In einer Ausgestaltung des erfindungsgemäßen Verfahrens weist die Beize zwischen etwa 30 g/l bis etwa 120 g/l Peroxid und eine Säure ausgewählt aus der Gruppe bestehend aus Schwefelsäure, Methansulfonsäure, Methandisulfonsäure oder Phosphorsäure auf. Vorteilhafterweise kann die Temperatur während des Beizschrittes bei Raumtemperatur liegen, wo durch auf zusätzliche Heizeinrichtungen und die damit verbundenen Energiekosten verzichtet werden kann. Geeignete Peroxide sind z.B. Salze der Peroxidischwefelsäure und / oder der Peroxischwefelsäure.

Die gebeizten Substratoberflächen werden in einer vorteilhaften Ausgestaltung des erfindungsgemäßen Verfahrens mit einer permanganathaltigen Behandlungslösung kontaktiert welche zwischen etwa 30 g/l bis etwa 60 g/l Permanganat in Form von Kalium- oder Natriumpermanganat und eine Säure ausgewählt aus der Gruppe bestehend aus Schwefelsäure, Phosphorsäure, Methansulfonsäure und Methandisulfonsäure aufweist.

Der pH-Wert der permanganathaltigen Behandlungslösung ist erfindungsgemäß < pH 5, bevorzugt < pH 3 und noch bevorzugter etwa pH 2.

Die Temperatur während der Kontaktierung der gebeizten Substratoberflächen mit der permanganathaltigen Behandlungslösung kann erfindungsgemäß zwischen 40 und 70°C, bevorzugt zwischen 50 und 60°C betragen.

Die mit der sauren permanganathaltigen Behandlungslösung kontaktierten Substratoberflächen werden anschließend in einer sauren peroxosulfathaltigen Aktivierungslösung aktiviert, welche zwischen etwa 30 g/l bis etwa 120 g/l Peroxosulfat und eine Säure ausgewählt aus der Gruppe bestehend aus Schwefelsäure, Methansulfonsäure, Methandisulfonsäure oder Phosphorsäure aufweist. Vorteilhafterweise entspricht die Aktivatorlösung hinsichtlich ihrer Zusammensetzung der Beizlösung.

In einer Ausgestaltung des erfindungsgemäßen Verfahrens wird die Aktivierung in der zuvor beschriebenen Aktivierungslösung unter Ultraschallagitation durchgeführt. Hierzu kann eine Ultraschallquelle in ein Aktivierungsbad eingebracht oder an diesem angeordnet sein.

Im Anschluss an die Aktivierung der zu metallisierenden Substratoberflächen werden diese mit einer wenigstens ein Thiophenderivat und wenigstens einer Sulfonsäure oder einem Sulfonsäurederivat aufweisenden Katalytlösung kontaktiert, welche als Thiophenderivat bevorzugt 3,4-Ethylendioxythiophen und als Sulfonsäurederivat bevorzugt Polystyrolsulfonsäure aufweist.

Die so behandelten Substratoberflächen können anschließend in einem geeigneten Elektrolyten zur galvanischen Abscheidung von Metallschichten metallisiert werden.

Ein solcher Elektrolyt kann beispielsweise ein saurer kupferhaltiger Elektrolyt zur Abscheidung von Kupferschichten sein.

In einer weiteren Ausgestaltung des erfindungsgemäßen Verfahrens kann vor einer galvanischen Beschichtung mit einer metallischen Schicht die behandelte Substratoberfläche in einer sauren Spüllösung, bevorzugt in einer schwefelsauren Spüllösung gespült werden.

Es liegt im Rahmen der Erfindung, dass zwischen den einzelnen Behandlungsschritten Spülschritte durchgeführt werden.

Ein besonderer Vorteil des erfindungsgemäßen Verfahrens ist es, dass bis auf die Kontaktierung der Substratoberfläche mit einer sauren permanganathaltigen Behandlungslösung sämtliche Verfahrensschritte bei Raumtemperatur ausgeführt werden können. Insbesondere hierdurch lassen sich gegenüber den aus dem Stand der Technik bekannten Verfahren deutliche Vorteile erzielen, da auf zusätzliche Einrichtungen zum Temperieren der Prozesslösungen verzichtet werden kann.

Die Behandlungszeiten der einzelnen Verfahrensschritte, mit Ausnahme des galvanischen Metallisierens, liegen in einem Bereich von ca. 1 bis 3 Minuten. Die Aktivierung der mit der sauren permanganathaltigen Behandlungslösung kontaktierten Substratoberfläche in der sauren peroxosulfathaltigen Aktivierungslösung kann sogar für weniger als 1 Minuten erfolgen. Gleiches gilt für die optionale Kontaktierung der behandelten Substratoberfläche vor einer galvanischen Metallisierung mit einer sauren, vorzugsweise schwefelsauren Spüllösung.

Das nachfolgende Ausführungsbeispiel steht exemplarisch für das erfindungsgemäße Verfahren, welches sich nicht auf das Ausführungsbeispiel beschränken läßt.

### Beispiel Nr. 1

Ein Polyamidsubstrat der Größe 600 x 500 mm wurde den nachfolgenden Behandlungsschritten unterzogen.

| | | |
|---|---|---|
| 3 min. | Ätzen | |
| | z. B. 100 g/l Natriumperoxidisulfat | |
| | 50 g/l Schwefelsäure | *Raumtemperatur* |

### Spülen

| | | |
|---|---|---|
| 3 min. | Konditionieren | |
| | Handelsüblicher Conditioner, im Hause im Einsatz | |
| | z. B. 40 ml/l Conditioner | *Raumtemperatur bis 40°C* |

### Spülen

| | |
|---|---|
| 3 min. | Aktivieren in permanganathaltiger, saurer Lösung |
| | z. B. 50 g/l Kaliumpermanganat |
| | Methansulfonsäure zur Einstellung des pH-Werts auf 2,0 +/-0,1, 50°C |

### Spülen

Aktivieren der mit Permanganat behandelten Oberflächen

| | |
|---|---|
| z. B. 100 g/l Natriumperoxidisulfat | |
| 50 g/l Schwefelsäure | |
| Ultraschallunterstützung | *Raumtemperatur* |

### Spülen

| | | |
|---|---|---|
| 2-3 min. | Kontaktieren der aktivierten Oberflächen mit einer thiophenderivathaltigen Lösung | |
| | z.B. 10 ml/l einer 3,4-ethylendioxithiophenhaltigen Lösung | |
| | 10 ml/l einer styrolsulfonsäurehaltigen Lösung | |
| | ca. 2 ml/l einer phosphorsäurehaltigen Lösung zur Einstellung des | |
| | pH-Werts von 2,0 +/-0,1 | *Raumtemperatur* |

### Spülen

### Dekapieren (optional)

### Metallisieren z. B. Envision Cuprostar LP1

### Beispiel Nr. 2

Ein Polyamidsubstrat der Größe 600 x 500 mm wurde den nachfolgenden Behandlungsschritten unterzogen:

| | | |
|---|---|---|
| 3 min. | Ätzen | |
| | z. B. 80 g/l Natriumperoxidisulfat | |
| | 50 g/l Schwefelsäure | *Raumtemperatur* |

### Spülen

| | | |
|---|---|---|
| 3 min. | Conditionieren | |
| | Handelsüblicher Conditioner, im Hause im Einsatz z. B. 40 ml/l Conditioner | *Raumtemperatur bis 40°C* |

### Spülen

| | | |
|---|---|---|
| 3 min. | Aktivieren in permanganathaltiger, saurer Lösung | |
| | z. B. 40g/l Kaliumpermanganat | |
| | Methansulfonsäure zur Einstellung des pH-Werts auf 2,0 +/-0,1 | 50°C |

### Spülen

| | |
|---|---|
| Aktivieren der mit Permanganat behandelten Oberflächen | |
| z. B. 80 g/l Natriumpersulfat (Caroat) | |
| 50 g/l Schwefelsäure | |
| Ultraschallunterstützung | *Raumtemperatur* |

### Spülen

| | |
|---|---|
| 2-3 min. | Kontaktieren der aktivierten Oberflächen mit einer thiophenderivathaltigen Lösung, |
| | z. B. 7 ml/l einer 3,4-ethylendioxithiophenhaltigen Lösung |
| | 7 ml/l einer styrolsulfonsäurehaltigen Lösung ca. 2 ml/l einer phosphorsäurehaltigen Lösung zur Einstellung des pH-Werts von 2,0 +/-0,1 *Raumtemperatur* |

### Spülen

### Dekapieren (optional)

### Metallisieren z. B. Envision Cuprostar LP1

### Beispiel Nr. 3

Ein Polyamidsubstrat der Größe 600 x 500 mm wurde den nachfolgenden Behandlungsschritten unterzogen:

| | | |
|---|---|---|
| 3 min. | Ätzen | |
| | z. B. | 80 ml/Wasserstoffperoxid (33%) |
| | | 50 g/l Schwefelsäure |
| | | 10 ml/l einer phonolsulfonsäurehaltigen Lösung *Raumtemperatur* |

### Spülen

| | | |
|---|---|---|
| 3 min. | Konditionieren | |
| | Handelsüblicher Conditioner, im Hause im Einsatz | |
| | z. B. 40 ml/l Conditioner | *Raumtemperatur bis 40°C* |

### Spülen

| | |
|---|---|
| 3 min. | Aktivieren in permanganathaltiger, saurer Lösung |
| | z. B. 36 g/l Natriumpermanganat |
| | Methansulfonsäure zur Einstellung des pH-Werts auf 2,0 +/-0,1 50°C |

### Spülen

| | | |
|---|---|---|
| Aktivieren der mit Permanganat behandelten Oberflächen | | |
| z. B. | 100 g/l Natriumperoxidisulfat | |
| | 50 g/l Schwefelsäure | |
| Ultraschallunterstützung | | *Raumtemperatur* |

### Spülen

| | | | |
|---|---|---|---|
| 2-3 min. | Kontaktieren der aktivierten Oberflächen mit einer | | |
| | thiophenderivathaltigen Lösung | | |
| | z. B. | 10 ml/l einer 3.4-ethylendioxithiophenhaltigen Lösung | |
| | | 10 ml/l einer styrolsulfonsäurehaltigen Lösung | |
| | | ca. 2 ml/l einer phosphorsäurehaltigen Lösung zur Einstellung | |
| | | des pH-Werts von 2,0 +/-0,1 | *Raumtemperatur* |

### Spülen

### Dekapieren (optional)

| | |
|---|---|
| Metallisieren | z. B. Envision Cuprostar LP1 |

### Beispiel Nr. 4

Ein Polyamidsubstrat der Größe 600 x 500 mm wurde den nachfolgenden Behandlungsschritten unterzogen.

| | | | |
|---|---|---|---|
| 3 min. | Ätzen | | |
| | z. B. | 100 g/l Natriumperoxidisulfat | |
| | | 50 g/l Schwefelsäure | *Raumtemperatur* |

### Spülen

| | | |
|---|---|---|
| 3 min. | Konditionieren | |
| | Handelsüblicher Conditioner, im Hause im Einsatz | |
| | z. B. 40 ml/l Conditioner | *Raumtemperatur bis 40°C* |

### Spülen

| | |
|---|---|
| 3 min. | Aktivieren in permanganathaltiger, saurer Lösung |
| | z. B. 50 g/l Kaliumpermanganat |
| | Methansulfonsäure zur Einstellung des pH-Werts auf 2,0 +/-0,1, 50°C |

### Spülen

| | | |
|---|---|---|
| Aktivieren der mit Permanganat behandelten Oberflächen | | |
| z. B. | 30 g/l Natriumperoxidisulfat | |
| | 50 g/l Schwefelsäure | |
| Ultraschallunterstützung | | *Raumtemperatur* |

### Spülen

| | | | |
|---|---|---|---|
| 2-3 min. | Kontaktieren der aktivierten Oberflächen mit einer thiophenderivathaltigen Lösung | | |
| | z.B. | 10 ml/l einer 3,4-ethylendioxithiophenhaltigen Lösung | |
| | | 10 ml/l einer styrolsulfonsäurehaltigen Lösung | |
| | | ca. 2 ml/l einer phosphorsäurehaltigen Lösung zur Einstellung des | |
| | | pH-Werts von 2,0 +/-0,1 | *Raumtemperatur* |

### Spülen

### Dekapieren (optional)

### Metallisieren z. B. Envision Cuprostar LP1

### Beispiel Nr. 5

Ein Polyamidsubstrat der Größe 600 x 500 mm wurde den nachfolgenden Behandlungsschritten unterzogen:

| | | | |
|---|---|---|---|
| 3 min. | Ätzen | | |
| | z. B. | 80 g/l Natriumperoxidisulfat | |
| | | 50 g/l Schwefelsäure | *Raumtemperatur* |

### Spülen

| | | |
|---|---|---|
| 3 min. Conditionieren | | |
| | Handelsüblicher Conditioner, im Hause im Einsatz | |
| | z. B. 40 ml/l Conditioner | *Raumtemperatur bis 40°C* |

### Spülen

| | |
|---|---|
| 3 min. | Aktivieren in permanganathaltiger, saurer Lösung |
| | z. B. 40g/l Kaliumpermanganat |
| | Methansulfonsäure zur Einstellung des pH-Werts auf 2,0 +/-0,1 50°C |

### Spülen

| | | |
|---|---|---|
| Aktivieren der mit Permanganat behandelten Oberflächen | | |
| z. B. | 40 g/l Natriumpersulfat (Caroat) | |
| | 50 g/l Schwefelsäure | |
| Ultraschallunterstützung | | *Raumtemperatur* |

### Spülen

| | | | |
|---|---|---|---|
| 2-3 min. | Kontaktieren der aktivierten Oberflächen mit einer | | |
| | thiophenderivathaltigen Lösung, | | |
| | z. B. | 7 ml/l einer 3,4-ethylendioxithiophenhaltigen Lösung | |
| | | 7 ml/l einer styrolsulfonsäurehaltigen Lösung | |
| | | ca. 2 ml/l einer phosphorsäurehaltigen Lösung zur Einstellung | |
| | | des pH-Werts von 2,0 +/-0,1 | *Raumtemperatur* |

### Spülen

### Dekapieren (optional)

### Metallisieren z. B. Envision Cuprostar LP1

### Beispiel Nr. 6

Ein Polyamidsubstrat der Größe 600 x 500 mm wurde den nachfolgenden Behandlungsschritten unterzogen:

| | | | |
|---|---|---|---|
| 3 min. | Ätzen | | |
| | z. B. | 80 ml/Wasserstoffperoxid (33%) | |
| | | 50 g/l Schwefelsäure | |
| | | 10 ml/l einer phonolsulfonsäurehaltigen Lösung | |
| | | | *Raumtemperatur* |

### Spülen

| | | |
|---|---|---|
| 3 min. | Konditionieren | |
| | Handelsüblicher Conditioner, im Hause im Einsatz | |
| | z. B. 40 ml/l Conditioner | *Raumtemperatur bis 40°C* |

### Spülen

| | |
|---|---|
| 3 min. | Aktivieren in permanganathaltiger, saurer Lösung |
| | z. B. 36 g/l Natriumpermanganat |
| | Methansulfonsäure zur Einstellung des pH-Werts auf 2,0 +/-0,1 |
| | 50°C |

### Spülen

| | | |
|---|---|---|
| Aktivieren | der mit Permanganat behandelten Oberflächen | |
| z. B. | 40 g/l Natriumperoxidisulfat | |
| | 50 g/l Schwefelsäure | |
| Ultraschallunterstützung | | *Raumtemperatur* |

### Spülen

| | | | |
|---|---|---|---|
| 2-3 min. | Kontaktieren der aktivierten Oberflächen mit einer | | |
| | thiophenderivathaltigen Lösung | | |
| | z. B. | 10 ml/l einer 3.4-ethylendioxithiophenhaltigen Lösung | |
| | | 10 ml/l einer styrolsulfonsäurehaltigen Lösung | |
| | | ca. 2 ml/l einer phosphorsäurehaltigen Lösung zur Einstellung | |
| | | des pH-Werts von 2,0 +/-0,1 | *Raumtemperatur* |

### Spülen

### Dekapieren (optional)

| | |
|---|---|
| Metallisieren | z. B. Envision Cuprostar LP1 |

Alternativ wurden all in den Beispielen 1 bis 6 angegebenen erfindungsgemäßen Verfahren mit FR 4- und plasmavorbehandelten Teflonsubstraten ausgeführt.

## Patentansprüche

1. Verfahren zur Direktmetallisierung von nicht leitfähigen Substratoberflächen, insbesondere Polyimidoberflächen, **gekennzeichnet durch** die aufeinanderfolgenden Verfahrensschritte:
- Beizen der Substratoberfläche mit einer sauren peroxidhaltigen Beizlösung
- Kontaktieren der gebeizten Substratoberfläche mit einer sauren per-manganathaltigen Behandlungslösung
- Aktivierung der behandelten Substratoberfläche in einer sauren peroxidhaltigen Aktivierungslösung
- Kontaktieren der aktivierten Substratoberfläche mit einer sauren, wenigstens ein Thiophenderivat und wenigstens ein Sulfonsäurederivat aufweisenden Katalytlösung und
- Metallisieren der so behandelten Substratoberfläche in einem sauren galvanischen Metallisierungsbad.

2. Verfahren nach Anspruch 1, **dadurch gekennzeichnet, dass** zwischen den einzelnen Verfahrensschritten Spülschritte erfolgen.

3. Verfahren nach einem der vorhergehenden Ansprüche, **dadurch gekennzeichnet, dass** die Beize zwischen etwa 30g/l bis etwa 120 g/l, bevorzugt etwa 80 g/l bis etwa 120 g/l Peroxid und eine Säure ausgewählt aus der Gruppe bestehend aus Schwefelsäure, Salzsäure oder Phosphorsäure aufweist.

4. Verfahren nach einem oder mehreren der vorhergehenden Ansprüche, **dadurch gekennzeichnet, dass** die permanganathaltige Behandlungslösung zwischen etwa 30 g/l und etwa 40 g/l Kaliumpermanganat und eine Säure ausgewählt aus der Gruppe bestehend aus Salzsäure, Schwefelsäure, Phosphorsäure, Methansulfonsäure und Methandisulfonsäure aufweist.

5. Verfahren gemäß Anspruch 4, wobei die Behandlungslösung einen pH-Wert von pH 5, bevorzugt pH 3, noch bevorzugter pH 2 aufweist.

6. Verfahren nach einem der vorhergehenden Ansprüche, **dadurch gekennzeichnet, dass** die Aktivierungslösung zwischen etwa 30 g/l bis etwa 120 g/l, bevorzugt etwa 80 g/l bis etwa 120 g/l Peroxid und eine Säure ausgewählt aus der Gruppe bestehend aus Schwefelsäure, Salzsäure oder Phosphorsäure aufweist.

7. Verfahren gemäß Anspruch 6, **dadurch gekennzeichnet, dass** die Aktivierungslösung mit der Beizlösung hinsichtlich ihrer Zusammensetzung identisch ist.

8. Verfahren nach einem der vorhergehenden Ansprüche, **dadurch gekennzeichnet, dass** die Aktivierung unter Ultraschallagitation erfolgt.

9. Verfahren nach einem oder mehreren der vorhergehenden Ansprüche, **dadurch gekennzeichnet, dass** die thiophenderivat- und sulfonsäurederivathaltige Behandlungslösung als Thiophenderivat wenigstens 3,4-Ethylendioxythiophen und als Sulfonsäurederivat wenigstens Styrolsulfonsäure aufweist.

10. Verfahren nach einem der vorhergehenden Ansprüche, **dadurch gekennzeichnet, dass** nach der Behandlung mit der thiophenderivat- und sulfonsäurederivathaltigen Behandlungslösung die Substratoberfläche mit einer sauren, bevorzugt schwefelsauren Spüllösung kontaktiert wird.

11. Verfahren nach einem der vorhergehenden Ansprüche, **dadurch gekennzeichnet, dass** die Substratoberfläche in einem kupferhaltigen Metallisierungsbad metallisiert wird.

## Claims

1. Method for direct metallization of non-conductive substrate surfaces, in particular polyimide surfaces;
**characterized by** the successive process steps:
- pickling said substrate surface with a peroxide containing acidic pickling solution;
- contacting the pickled substrate surface with a permanganate containing acidic treatment solution;
- activating the treated substrate surface in a peroxide containing acidic activating solution;
- contacting the activated substrate surface with an acidic catalytic solution containing at least one thiophene derivative and at least one sulfonic acid derivative; and
- metallizing the thus treated substrate surface in an acidic galvanic metallization bath.

2. Method according to claim 1, **characterized in that** rinsing steps are carried out between the individual process steps.

3. Method according to any one of the preceding claims, **characterized in that** the pickle includes between about 30 g/l to about 120 g/l, preferably about 80 g/l to about 120 g/l peroxide and an acid selected from the group consisting of sulfuric acid, hydrochloric acid and phosphoric acid.

4. Method according to one or more of the preceding claims, **characterized in that** the permanganate containing treatment solution comprises between about 30 g/l and about 40 g/l of potassium permanganate and an acid selected from the group consisting of hydrochloric acid, sulfuric acid, phosphoric acid, methane sulfonic acid and methane disulfonic acid.

5. Method according to claim 4, wherein the treatment solution has a pH-value of pH 5, preferably pH 3, more preferably pH 2.

6. Method according to any one of the preceding claims, **characterized in that** the activating solution comprises between about 30 g/l to about 120 g/l, preferably about 80 g/l to about 120 g/l peroxide and an acid selected from the group consisting of sulfuric acid, hydrochloric acid and phosphoric acid.

7. Method according to claim 6, **characterized in that** the activating solution is identical to the pickling solution with respect to its composition.

8. Method according to any one of the preceding claims, **characterized in that** the activation is carried out under ultrasonic agitation.

9. Method according to one or more of the preceding claims, **characterized in that** the thiophene derivatives and sulfonic acids containing treatment solution comprises at least 3,4-ethylenedioxythiophene as thiophene derivative and at least styrene sulfonic acid as sulfonic acid derivative.

10. Method according to any one of the preceding claims, **characterized in that** after the treatment with the thiophene derivatives and sulfonic acid derivatives containing treatment solution the substrate surface is contacted with an acidic, preferably sulfuric acid rinse solution.

11. Method according to any one of the preceding claims, **characterized in that** the substrate surface is metallized in a copper containing metallization bath.

## Revendications

1. Procédé de métallisation directe de surfaces de substrats non conducteurs, notamment de surfaces en polyimide, **caractérisé par** les étapes de procédé se successives :
- teinture de la surface du substrat avec une solution acide de teinture contenant un peroxyde
- mise en contact de la surface de substrat teintée avec une solution de traitement acide contenant du permanganate
- activation de la surface de substrat traitée dans une solution d'activation acide contenant un peroxyde
- mise en contact de la surface de substrat activée avec une solution acide de catalyse présentant au moins un dérivé de thiophène et au moins un dérivé d'acide sulfonique, et
métallisation de la surface de substrat ainsi traitée dans un bain de métallisation galvanique acide.

2. Procédé selon la revendication 1, **caractérisé en ce que** des étapes de rinçage sont effectuées entre les étapes de procédé individuelles.

3. Procédé selon l'une des revendications précédentes, **caractérisé en ce que** la teinture présente entre environ 30 g/l et environ 120 g/l, de préférence entre environ 80 g/l et environ 120 g/l, de peroxyde et un acide choisi dans le groupe constitué par l'acide sulfurique, l'acide chlorhydrique ou l'acide phosphorique.

4. Procédé selon l'une ou plusieurs parmi les revendications précédentes, **caractérisé en ce que** la solution de traitement contenant du permanganate présente entre environ 30 g/l et environ 40 g/l de permanganate de potassium et un acide choisi dans le groupe constitué par l'acide chlorhydrique, l'acide sulfurique, l'acide phosphorique, l'acide méthane sulfonique et l'acide méthane disulfonique.

5. Procédé selon la revendication 4, dans lequel la solution de traitement présente une valeur de pH de pH 5, de préférence de pH 3, de manière encore préférée de pH 2.

6. Procédé selon l'une des revendications précédentes, **caractérisé en ce que** la solution d'activation présente entre environ 30 g/l et environ 120 g/l, de préférence entre environ 80 g/l et environ 120 g/l, de peroxyde et un acide choisi dans le groupe constitué par l'acide sulfurique, l'acide chlorhydrique ou l'acide phosphorique.

7. Procédé selon la revendication 6, **caractérisé en ce que** la solution d'activation est identique en ce qui concerne la composition à la solution de teinture.

8. Procédé selon l'une des revendications précédentes, **caractérisé en ce que** l'activation est effectuée sous agitation ultrasonore.

9. Procédé selon l'une ou plusieurs parmi les revendications précédentes, **caractérisé en ce que** la solution de traitement contenant le dérivé de thiophène et le dérivé d'acide sulfonique présente au moins du 3,4-éthylène dioxythiophène en tant que dérivé de thiophène et au moins de l'acide styrène sulfonique en tant que dérivé d'acide sulfonique.

10. Procédé selon l'une des revendications précédentes, **caractérisé en ce que** la surface de substrat est mise e contact avec une solution de rinçage acide, de préférence d'acide sulfurique après le traitement avec la solution de traitement contenant un dérivé de thiophène et un dérivé d'acide sulfonique.

11. Procédé selon l'une des revendications précédentes, **caractérisée en ce que** la surface de substrat est métallisée dans un bain de métallisation contenant du cuivre.
